# EUROPEAN PATENT SPECIFICATION

(11) **EP 4 235 812 B1**
(45) Date of publication and mention of the grant of the patent: **29.10.2025**
(21) Application number: 23158385.7
(22) Date of filing: 24.02.2023
(51) Int. Cl.: H10F 19/80, H10F 19/90

(54) **ENCAPSULANT FILM AND MANUFACTURING METHOD THEREOF, SOLAR CELL MODULE AND MANUFACTURING METHOD THEREOF**
VERKAPSELUNGSFOLIE UND HERSTELLUNGSVERFAHREN DAFÜR, SOLARZELLENMODUL UND HERSTELLUNGSVERFAHREN DAFÜR
FILM D'ENCAPSULATION ET SON PROCÉDÉ DE FABRICATION, MODULE DE CELLULE SOLAIRE ET SON PROCÉDÉ DE FABRICATION

(30) Priority: 25.02.2022 CN 202210177237
(43) Date of publication of application: 30.08.2023
(73) Proprietor: Ja Solar Technology Yangzhou Co., Ltd., Yangzhou, Jiangsu 225009 (CN)
(72) Inventor: CHEN, Hongyue, Yangzhou City, Jiangsu Province, 225009 (CN); ZHOU, Yanfang, Yangzhou City, Jiangsu Province, 225009 (CN); NIU, Xinwei, Yangzhou City, Jiangsu Province, 225009 (CN)
(74) Representative: Sun, Yiming

(56) References cited:
- CN-U- 207 602 592
- CN-U- 214 991 264
- JP-A- 2006 128 289
- JP-A- 2012 059 763
- JP-A- 2012 204 735
- US-A1- 2010 147 377

## Description

### TECHNICAL FIELD

Embodiments of the present disclosure relate to an encapsulant film and a manufacturing method thereof, and a manufacturing method of a solar module.

### BACKGROUND

Along with continuous development of the industry, manufacturing ability of crystalline silicon continues to increase, power and efficiency of a solar cell module are increasing day by day, and solar cell electricity generation unit cost is gradually decreasing. However, as the solar cell module takes up less and less in system cost, a downstream demand for a more efficient and longer-life module is becoming stronger and stronger.

An existing double-glass module can effectively use incident light from front and back surfaces to significantly improve power generation efficiency, but the front and back sides of the double-glass module are hard-connected, and an amount of packaging film used is relatively large. Thus, how to reduce the amount of film used and improve reliability is an urgent problem to be solved.

Document CN214991264U discloses an encapsulant film for a solar module with thickened portions aligned with welding strips.

### SUMMARY

An embodiment of the present disclosure provides an encapsulant film according to claim 1, a manufacturing method thereof according to claim 9, a manufacturing method of a solar module according to claim 7, which can reduce the amount of encapsulant used on the solar cell module, for example, on the back surface, and reduce the thickness of the solar cell module and the distance between the back plate and the solar cells, improve the stability and the anti-PID(Potential Induced Degradation) performance of the solar cell module.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
FIG. 1A is a plan view of an encapsulant film according to an embodiment of the present disclosure;
FIG. 1B is a partial cross-sectional view of the encapsulant film taken along line A-A' in FIG. 1A;
FIG. 2A is a plan view of another exemplary encapsulant film;
FIG. 2B is a cross-sectional view of the encapsulant film taken along line B-B' in FIG. 2A;
FIG. 3A is a plan view of another exemplary encapsulant film;
FIG. 3B is a cross-sectional view of the encapsulant film taken along line C-C' in FIG. 3A;
FIG. 4A is a cross-sectional view of a solar cell module before lamination;
FIG. 4B is a cross-sectional view of the solar cell module after lamination; and
FIG. 5 is a schematic diagram of a manufacturing method of an encapsulant film.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms, such as "first," "second," or the like, which are used in the description and the claims of the present disclosure, are not intended to indicate any sequence, amount or importance, but for distinguishing various components. Likewise, the term, such as "an", "a", "the" or the like, does not intended to limit the number, but indicates at least one. The terms, such as "comprise/comprising," "include/including," or the like are intended to specify that the elements or the objects stated before these terms encompass the elements or the objects and equivalents thereof listed after these terms, but not preclude other elements or objects. The terms, such as "connect/connecting/connected," "couple/coupling/coupled" or the like, are not limited to a physical connection or mechanical connection, but may include an electrical connection/coupling, directly or indirectly. The terms, "on," "under," "left," "right," or the like are only used to indicate relative position relationship, and when the absolute position of the object which is described is changed, the relative position relationship may be changed accordingly.

For a single-glass solar cell module or a double-glass solar cell module, presence of sodium ions in the glass is a big challenge to anti-Potential Induced Degradation (PID) performance of the module. When a PID phenomenon occurs in the module, a power loss of the module is severe. There are many reasons for the PID phenomenon, and a mechanism thereof is very complicated, but one of the important conditions is water vapor. In addition, currently a back surface of a P-type crystalline silicon solar cell with a largest market share is field passivated, and AlxOx is electronegativity, which has an attractive effect on Na+, so now a main P-type crystalline silicon double-glass module is attenuated more severely when the PID phenomenon occurs, and some power attenuation may be as high as 50%. Therefore, how to reduce an impact of water vapor infiltration and sodium ions on the module, especially an impact on the solar cell on the back surface is also an important ongoing research issue for the solar cell module.

Embodiments of the present disclosure provide an encapsulant film and a solar cell module using the encapsulant film. An orthogonal projection of the first region of the encapsulant film on a surface where the solar cell module is located overlaps at least partially an orthogonal projection of at least one of the plurality of welding strips, wherein, a film thickness of the first region is different from a film thickness of an other region of the encapsulant film; for example, the film thickness of the first region is greater than the film thickness of the other region. In this way, when the encapsulant film is used to manufacture a solar cell module, the first region with a thicker encapsulant is directly opposite to the welding strip, so that when the solar cell module is subsequently laminated, as the encapsulant above the welding strip is relatively thick, the encapsulant in this region will not all flow out of a space between the welding strip and the back plate material due to pressure and temperature; and meanwhile, the other region, such as a region where the encapsulant is relatively thin or a hollow region, will also have encapsulant as the encapsulant flows around, thus ensuring that the encapsulant remains between the back plate and the welding strip after the lamination is finished, and wraps a back surface of the welding strip away from the solar cell, that is, a surface of the welding strip facing the back plate material, so as to ensure that a flexible encapsulant is filled between the welding strip and the back plate material (especially a glass back plate) to fully protect the welding strip, improve a yield of the solar cell and avoid defects such as breakage of the welding strip of the solar cell and damage to the solar cell; moreover, the encapsulant will also flow to other regions, so that it can be completely distributed between a solar cell string and the back plate and/or front plate material, and completely package a charged body, for example, the solar cell string. Furthermore, since the encapsulant is also filled between the welding strip protruding from a surface of the solar cell and the back plate material, there is a packaging film everywhere between the back plate material and the solar cell, and the back plate material can be firmly attached to the solar cell, so that the encapsulant can connect the front plate material, cell string and back plate material of the module as a whole. Moreover, use of the encapsulant film with uneven thickness or even hollowing out can reduce the amount of encapsulant used on the back surface, reduce the space between the back plate material and the solar cell, and improve energy conversion efficiency of the back of the solar cell.

Hereinafter, the encapsulant film and manufacturing method thereof, and the solar cell module and manufacturing method thereof according to the embodiments of the present disclosure will be illustrated with reference to the accompanying drawings.

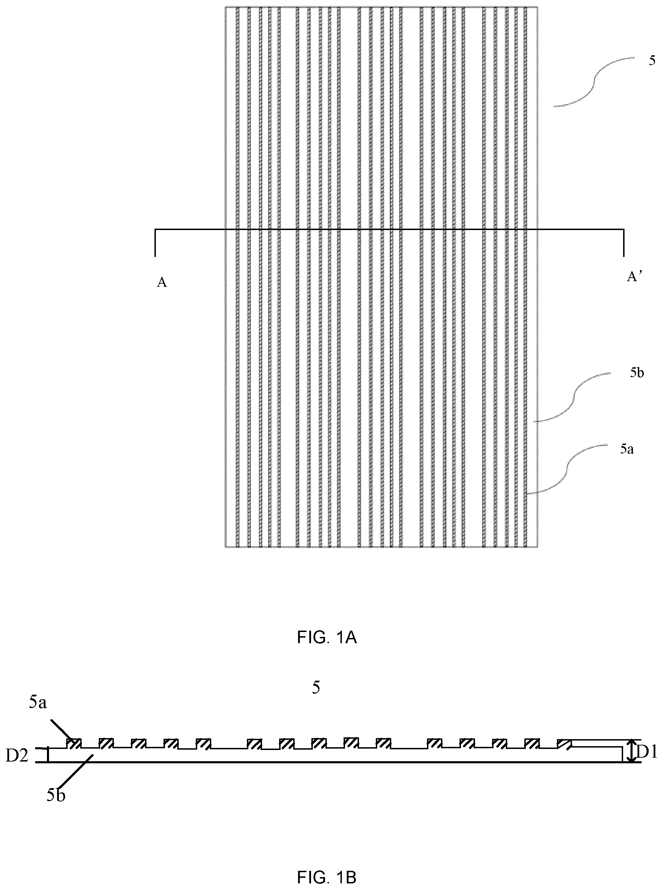

FIG. 1A shows a plan view of an encapsulant film 5, and FIG. 1B shows a partial cross-sectional view of the encapsulant film 5 taken along line A-A' in FIG. 1A. For simplicity of illustration, the entire cross-sectional view of the encapsulant film 5 is not shown in FIG. 1B, but the other regions are also of the same structure. The encapsulant film is configured for a solar cell module. The solar cell module includes a plurality of welding strips. As shown in FIGS. 1A and 1B, the encapsulant film 5 includes a first region 5a, and an orthogonal projection of the first region 5a on a surface where the solar cell module is located overlaps at least partially an orthogonal projection of at least one of the plurality of welding strips. A thickness D1 of the encapsulant film in the first region 5a is different from a thickness D2 of the encapsulant film in an other region, for example, the thickness D1 of the encapsulant film in the first region 5a is greater than the thickness D2 of the encapsulant film in the other region.

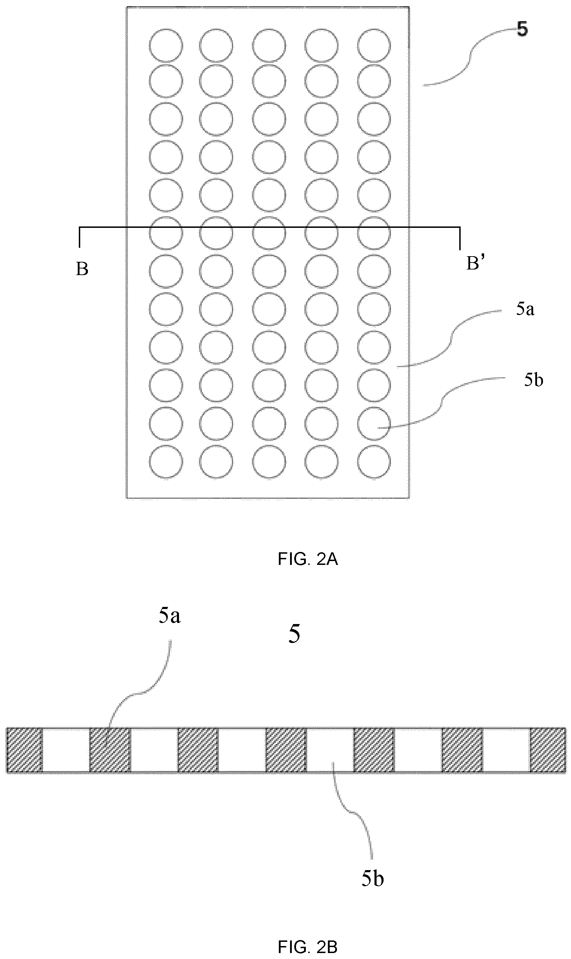

For example, the thickness D2 of the encapsulant film in the other region may be zero. FIGS. 2A and 2B show an encapsulant film 5 in a hollow shape, of which FIG. 2B is a cross-sectional view of the encapsulant film 5 taken along line B-B' in FIG. 2A. The encapsulant film 5 is in a hollow grid shape, a region corresponding to the welding strip is the first region 5a, and the other region 5B is in the hollow shape. The hollow grid shape of the encapsulant film 5 is formed by the first regions 5a connected to each other, the first regions 5a are a framework of the hollow grid shape, and the other regions 5b are hollow regions of the encapsulant film in the hollow shape. In FIG. 2B, the plan view of hollow pattern formed by the hollow regions is in a circular hole shape, and the hollow pattern may also be strip-shaped, square or elliptical, etc., which is not limited in the embodiments of the present disclosure, and may be selected by those skilled in the art as required.

For example, the solar cell module includes a solar cell string and a plurality of welding strips arranged on the solar cell string, wherein the solar cell string includes a plurality of solar cells, and an orthogonal projection of the first region 5a of the encapsulant film on a surface where the solar cell module is located, i.e., on a surface where the solar cell string is located, overlaps at least partially an orthogonal projection of at least one of the plurality of welding strips.

For example, the orthogonal projection of the first region 5a on the surface where the solar cell string of the solar cell module is located overlaps at least partially the orthogonal projection of at least one of the plurality of welding strips, which may include: the orthogonal projection of the first region 5a on the surface where the solar cell string is located overlaps partially one, two or all of the plurality of welding strips, which is not limited in embodiments of the present disclosure. The orthogonal projection of the first region 5a on the surface where the solar cell string is located overlaps at least partially an orthogonal projection of a welding strip, which may be that the orthogonal projection of the first region partially overlaps or completely overlaps the orthogonal projection of the welding strip. Completely overlapping may refer to completely coincidence or the orthogonal projection of the welding strip falling within a range of the orthogonal projection of the first region.

For example, when the film thickness D2 of the other region is not zero, the encapsulant film in the first region may be two layers of encapsulant, while the encapsulant in the other region may be one layer of encapsulant. That is, in the first region, an adhesive film spacer may be added on the entire layer of encapsulant in a region corresponding to the welding strip, so that the encapsulant film in the first region is formed by two layers of encapsulant, causing the film thickness of the first region to be greater than the film thickness of the other region. However, the embodiments of the present disclosure are not limited thereto.

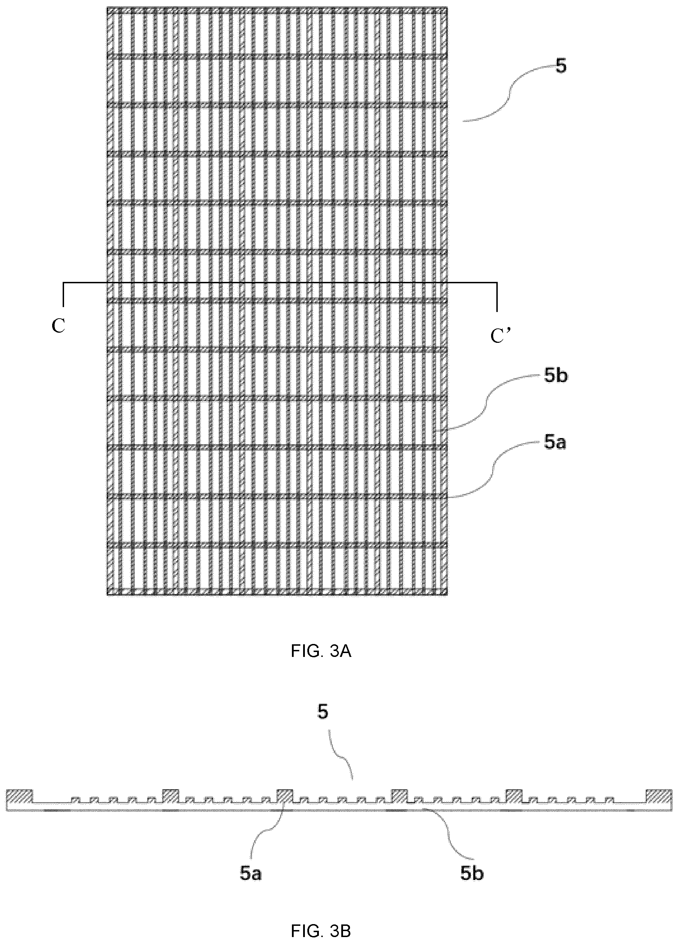

Further, FIG. 3A shows a plan view of another exemplary encapsulant film 5, and FIG. 3B shows a cross-sectional view of the encapsulant film 5 taken along line C-C' in FIG. 3A. As shown in FIGS. 3A and 3B, the orthogonal projection of the first region 5a of the encapsulant film 5 on the surface where the solar cell module is located may also overlap at least partially with an orthogonal projection of a gap between the solar cells of the solar cell module on a surface where the solar cell module is located, for example, both completely overlap, partially overlap, or the orthogonal projection of the gap between the solar cells falls within the range of the orthogonal projection of the first region. As can be seen from FIGS. 3A and 3B, the first region 5a is also correspondingly provided in a gap between the solar cells 19 in a longitudinal direction, i.e., in a gap between the solar cells arranged parallel to an extending direction of the welding strip; and the first region 5a is also correspondingly provided in a gap between the solar cells in a transverse direction, i.e., in a gap between the solar cells arranged perpendicular to the extending direction of the welding strip. Further, referring to FIG. 3B, FIG. 3B shows that the first region 5a corresponding to the gap between the solar cells in the transverse direction is also formed to have a greater thickness, that is, to have a film thickness greater than the film thickness of the other region. This is only an example, and it should be clear to those skilled in the art that the first region corresponding to the gap between the solar cells in the longitudinal direction may also be formed to have a film thickness greater than the thickness of the other region, which can better bond the back plate and the front plate to improve stability of the solar cell module.

In FIGS. 3A and 3B, the first region corresponding to the gap between the solar cells is shown to be thicker than the first region corresponding to the welding strip; in the gap between the solar cells, a distance between the back plate material and the front plate material is relatively large, so more encapsulants are required to fill in, so as to better bond the front plate, the backplate and the solar cells, and improve the stability of the solar cell module. However, it should be clear to those skilled in the art that the thickness of the first region corresponding to the gap between the solar cells may also be equal to the thickness of the first region corresponding to the welding strip, which can still achieve an effect of better bonding the front plate and back plate materials and the solar cells; nevertheless, the thickness of the first region corresponding to the gap between the solar cells is shown to be greater than the thickness of the first region corresponding to the welding strip, which can on such basis further improve the bonding effect on the solar cell module and improve the stability.

Further, the first region of the encapsulant film may also correspond to the peripheral region of the solar cell string. The film thickness of the first region corresponding to the peripheral region may be equal to or greater than the film thickness of the first region corresponding to the gap between the solar cells, and may be equal to or greater than the thickness of the first region corresponding to the welding strip, which is not limited in the embodiments of the present disclosure, and may be selected by those skilled in the art as required.

In FIGS. 1B and 3B, a column of solar cells in the longitudinal direction is provided with five welding strips. These are examples, and are only for illustrating the technical solution of the present disclosure, but are not intended to limit the present disclosure. In actual situations, those skilled in the art may select the corresponding number of welding strips as required.

For example, in the encapsulant film 5, the film thickness of the first region 5a may be 0.4 mm to 0.6 mm, and the film thickness of the other region may be 0 mm to 0.3 mm, such as 0.1 mm, and 0.2 mm. The thickness of the first region corresponding to the welding strip, the gap between the cells as well as the peripheral region of the solar cell module may be selected from 0.4 mm to 0.6 mm.

Alternatively, the film thickness in the first region may have a uniform thickness, or may have a non-uniform thickness, but the film thickness of each region in the first region is greater than the film thickness in the other region except the first region, which is not limited in the embodiments of the present disclosure.

For example, in the embodiments of the present disclosure, the encapsulant film may be formed by the encapsulant. The encapsulant may include one or more of ethylene-vinyl acetate copolymer (EVA), polyolefin elastomer (POE) and polyvinyl butyral (PVB). For example, the encapsulant may be ethylene-vinyl acetate copolymer (EVA), polyolefin elastomer (POE) or polyvinyl butyral (PVB), or may be a mixture of any two of the three or a mixture of the three.

For example, the polyolefin elastomer may be one or more of copolymers of ethylene and butene, pentene, hexene or octene. When the encapsulant is ethylene-vinyl acetate copolymer (EVA), EVA materials with different vinyl acetate (VA) contents may be used. When the encapsulant is polyolefin elastomer, copolymers of ethylene and butene, pentene, hexene or octene or copolymers of ethylene and butene, pentene, hexene or octene with different ethylene contents, a mixture of two of EVA, POE and PVB with different corresponding contents, or a mixture of the three with different contents, may be used. When the encapsulant film includes encapsulants with the same component or composition but with different contents, they may be regarded as different encapsulants. For example, when the encapsulant is ethylene-vinyl acetate copolymer, when the components are the same but the VA content is different, it may be considered as a different encapsulant. When the encapsulant is a mixture of polymer materials, when the composition is the same but the content is different, for example, when the encapsulant includes a mixture of EVA and POE, if the content of EVA is different, it may be considered as a different encapsulant. Only these two examples are given, and those skilled in the art may deduce other cases, so details will not be described here.

Alternatively, the encapsulant may include a co-extruded material (EPE) of ethylene-vinyl acetate copolymer, polyolefin elastomer and ethylene-vinyl acetate copolymer; for example, the encapsulant film includes three layers, that is, it has POE sandwiched between two layers of EVA and is formed by a co-extrusion machine, and a main purpose of adding POE therebetween is to reduce the PID phenomenon of the module. It should be clear to those skilled in the art that the thickness of each of the three layers may be changed according to types of the solar cell and the module, for example, a bulk density of each layer of the encapsulant film formed by the three-layer co-extruded material may be 140 g/m²/200 g/m²/140 g/m², to form an adhesive film with a bulk density of 480g/m². At present, the bulk density is usually used to control the thickness.

For example, the packaging film material may include a same polymer material or a same mixture of polymer materials, that is, the first region 5a and the other region include the same polymer material, that is, the polymer material with same composition and content or the same mixture of polymer materials, that is, a mixture of polymer materials with the same composition and content; or, the encapsulant in the first region 5a and the encapsulant in the other region are polymer materials with the same composition and different contents; or, the encapsulant film includes a mixture of polymer materials, the mixtures of the first region and the other region may have the same composition but different content of at least one composition, or different composition and different content, which will not be listed here.

Alternatively, the first region 5a and the other region may include the same polymer material or the same mixture of polymer materials, for example, the encapsulant film may be ethylene-vinyl acetate copolymer (EVA), polyolefin elastomer (POE ), polyvinyl butyral ester (PVB), a mixture of EVA and POE, a mixture of EVA and PVB, a mixture of POE and PVB, or a mixture of the three, but the components or composition of the encapsulant in all regions are the same and the content is the same, for example, EVA with a same VA content, a mixture of EVA and POE with same EVA and same POE as well as same EVA and POE content, etc., which will not be listed here.

For example, the first region 5a and the other region may include different polymer materials or different mixtures of polymer materials. For example, the first region 5a and the other region may adopt polymer materials with same composition but different contents. When the first region 5a and the other region are made of EVA, VA contents of the EVA in the first region 5a and in the other region may be different. The same is true for other materials, which will not be listed one by one here.

The encapsulant film of the embodiments of the present disclosure is configured for a solar cell. By forming the encapsulant film in such a way that the thickness of the first region corresponding to the welding strip is different from the thickness of the other region, for example, greater than the thickness of the other region, in a case where the amount of encapsulant used is reduced, a distance between the back plate and the solar cells is reduced, and the welding strips is fully protected, to ensure that the back plate is fully bonded with the solar cells and the welding strips. Further, the first region may also correspond to the gap between the solar cells and/or the peripheral region of the solar cell module, so as to further improve a bonding strength among the back plate, the front plate and the solar cell, and improve the performance and stability of the solar cell module.

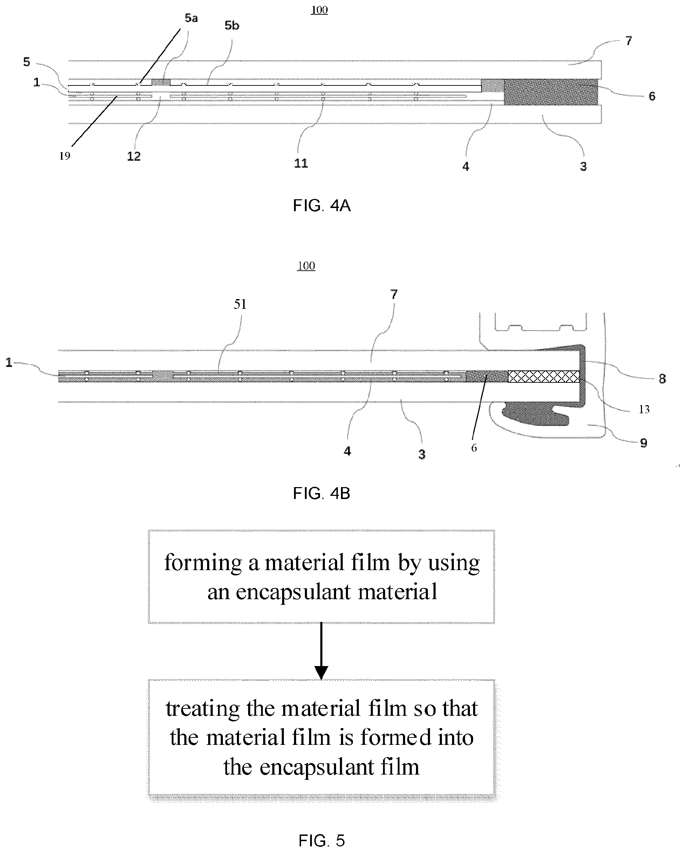

In another aspect, an embodiment of the present disclosure further provides a solar cell module including any encapsulant film described above, as shown in FIGS. 4A and 4B. FIG. 4A shows a cross-sectional view of the solar cell module before lamination, and FIG. 4B shows a cross-sectional view of the solar cell module after lamination, that is, a finally formed solar cell module. The encapsulant film used in FIGS. 4A and 4B is the encapsulant film shown in FIGS. 3A and 3B, and the encapsulant films in other examples are similar, which will not be given here for brevity. As shown in FIGS. 4A and 4B, a solar cell module 100 includes: a solar cell string 1, including a plurality of solar cells 19 connected to each other; an encapsulant layer 51, arranged on at least one surface of the solar cell string, and formed by any encapsulant film 5 described above; a plurality of welding strips 11, arranged on at least one surface of the solar cell string between the solar cell string 1 and the encapsulant layer 51, wherein the encapsulant film 5 includes a first region 5a, an orthogonal protection of the first region on a surface where the solar cell string 1 is located overlaps at least partially an orthogonal projection of at least one of the plurality of welding strips, and a film thickness of the first region 5a is different from (e.g., greater than) a film thickness of an other region 5b.

For example, the orthogonal protection of the first region 5a on the surface where the solar cell string 1 is located overlaps at least partially the orthogonal projection of at least one of the plurality of welding strips, which may include: the orthogonal protection of the first region 5a on the surface where the solar cell string 1 is located overlaps at least partially one, two or all of the plurality of welding strips, which is not limited in embodiments of the present disclosure. The orthogonal projection of the first region 5a on the surface where the solar cell string 1 is located overlaps at least partially an orthogonal projection of a welding strip, which may be that the orthogonal projection of the first region completely overlaps the orthogonal projection of the welding strip, the orthogonal projection of the welding strip falls within the range of the orthogonal projection of the first region, or the orthogonal projection of the first region partially overlaps the orthogonal projection of the welding strip, which is not limited by the embodiments of the present disclosure, and may be selected by those skilled in the art as required.

FIB. 4B shows a cross-sectional view of the solar cell module after lamination. As can be seed from FIG. 4B, there is an encapsulant layer 51 between the welding strip and the back plate material 7 after lamination. Therefore, for the solar cell module using the encapsulant film of the embodiments of the present disclosure, no matter in what situation, it can reduce the amount of the encapsulant used, while ensuring that after lamination, the encapsulant film can wrap the back surface of the welding strip away from the solar cell, that is, a surface facing the back plate material, to fully protect the welding strip.

For example, when the orthogonal projection of the welding strip falls completely within the range of the orthogonal projection of the first region, the welding strip can be wrapped by a thicker encapsulant film, so that the welding strip can be well protected from being damaged. There is no region where the welding strip directly contacts the back plate material between the back plate material and the solar cell, an encapsulant film is completely disposed therebetween, and the two are well bonded, thereby further improving the performance of the solar cell module.

For brevity, a material of the encapsulant film will not be specifically described here. For details, please refer to the above examples. Herein, only the solar cell module including the packaging film and the case where the packaging film is arranged in the solar cell module are described.

In FIG. 4A, in the gap between the solar cells, there is also correspondingly provided a thicker first region. Thus, in the solar cell module after lamination in FIG. 4B, the encapsulant is also fully filled between the back plate material 7 and the front plate material 3, so that the back plate, the front plate and the solar cells can be well fixed.

For example, in the solar cell module of the embodiment of the present disclosure, the encapsulant film 5 and the plurality of welding strips 11 may be arranged on the back surface of the solar cell string 1. The solar cell module further includes: a back plate material, arranged on a side of the encapsulant film away from the welding strips.

For example, the back plate material may be an inorganic or organic material, such as glass or tetrafluorocloth.

In the solar cell module shown in FIGS. 4A and 4B, the encapsulant film 5 is arranged on the back surface of the solar cell string, and the back plate material is shown as glass; before lamination, as shown in FIG. 4A, the encapsulant film 5 is arranged between the solar cell string 1, the welding strip 11 and the back plate material 7, and the first region 5a of the encapsulant film is aligned with at least one welding strip 11, for example, with all the welding strips 11. The alignment here may be that a center of the welding strip 11 is aligned with a center of the first region 5a, or may be that at least a portion of the orthogonal projection of the welding strip 11 on the surface where the solar cell string 11 is located overlaps the first region 5a. For example, the orthogonal projection of the first region 5a may completely cover the orthogonal projection of the welding strip, or the two orthogonal projections partially overlap.

It should be noted that, it may be an upper side of the encapsulant film in FIG. 3B that contacts the welding strip 11, or it may be a lower side of the encapsulant film in FIG. 3B that contacts the welding strip 11.

For example, the center of the welding strip 11 may be aligned with the center of the first region 5a, and an area of the orthogonal projection of the first region 5a is greater than or equal to an area of the orthogonal projection of the welding strip, so that the back surface of the welding strip after lamination can be fully protected by the encapsulant film, which reduces a possibility of damage to the welding strip while reducing the film thickness, and improves the performance of the solar cell module.

In a lamination process of the solar cell module, the encapsulant film turns into a molten state by applying pressure and heat. However, for the first region 5a, since a thicker encapsulant film is provided to correspond to the welding strip, although the encapsulant will flow away from this region during lamination, due to being relatively thicker, it can be ensured that a space between the welding strip and the back plate material can also be filled with soft encapsulant after lamination, so as to protect the solar cell from being damaged during the manufacturing process of the module, and protect the welding strip from being damaged such as breakage. In addition, because the encapsulant film flows out to other regions, there is encapsulant everywhere between the back plate material and the solar cell string, and there will be no case where all the encapsulant between the welding strip and the back plate material flows out and the welding strip directly contacts the back plate material, so that it can also ensure that there is an encapsulant that can connect the solar cell string and the back plate material to form a whole and improve the performance of the solar cell module.

Further, the solar cell module 100 may further include an encapsulant layer 4 on the front surface of the solar cell string 1, a welding strip 11 and a front plate material 3. For example, the front plate material 3 may be glass.

For example, the encapsulant layer 4 on the front surface may use an encapsulant film with a uniform thickness, or may be consistent with the encapsulant film used on the back surface. For example, such an encapsulant film is used: the region corresponding to at least one welding strip is thicker and/or the region corresponding to the gap between the solar cells is thicker and/or the region corresponding to the peripheral region of the solar cell module is thicker, which may be selected by those skilled in the art as required.

FIG. 4B shows a case where the front plate material is glass and the back plate material is glass, that is, a case of a double-glass module. The solar cell module in the embodiments of the present disclosure may also be that the front plate material is glass and the back plate material is tetrafluorocloth, that is, a case of a single-glass module. An example for the single-glass module is not shown for brevity.

Alternatively, in the solar cell module, the encapsulant film and the plurality of welding strips are arranged on the back surface and the front surface of the solar cell string. The solar cell module further includes: a back plate material, arranged on the back surface and on a side of the encapsulant layer away from the welding strips; and a front plate material, arranged on the front surface and on the side of the encapsulant layer away from the welding strips, wherein the back plate material and the front plate material are glass.

What needs to be explained here is that since the encapsulant film will flow during the lamination process, referring to FIGS. 4A and 4B and FIGS. 3A and 3B, the first region corresponding to the welding strip is thickened before lamination, the encapsulant in the first region will flow during lamination, and the packaging film will become thinner after lamination. In this way, after lamination, the first region corresponding to the welding strip may be thicker or thinner than the other region, but in either case, after lamination, the welding strip will be protected by the adhesive film and will not directly contact the back plate material.

In actual situations, those skilled in the art may set the thickness of the first region according to needs and conditions of the encapsulant. For example, the thickness of the first region may be between 0.4 mm and 0.6 mm, which is not limited in the embodiments of the present disclosure.

For example, as shown in FIG. 4B, after lamination, the encapsulant films on the front surface and the back surface of the solar cell will flow together where there is a gap, resulting in the case shown in FIG. 4B. Furthermore, for the double-glass module shown in FIGS. 4A and 4B, in order to protect the encapsulant inside the module and ensure that light transmittance and insulation property of the encapsulant of the module can be maintained after various aging, double-layer sealing is performed on a periphery of the solar cell module. As shown in FIG. 4B, a sealing material 6 is also provided between the back plate material and the front plate material of the double-glass module, a sealant 8 is provided on an outer side of the back plate material and the front plate material in the periphery of the solar cell module, and a frame 9 is further provided, to complete manufacturing of the solar cell module.

Further, the solar cell module may also include a desiccant 13 located between the sealing material and the sealant in a direction parallel to the surface where the solar cell module is located, thereby further preventing water vapor from infiltrating from around the module to damage the solar cell module, and improving the stability and performance of the solar cell module.

For the solar cell module of the embodiment of the present disclosure, since a thicker encapsulant film is used to form an encapsulant layer at least in a region corresponding to the welding strip, in a case where the amount of encapsulant used is reduced, for example, in a case where the amount of encapsulant used for the back surface is reduced, it can be ensured that the welding strip can be wrapped by a flexible material during lamination, to prevent the welding strip from being damaged, enhance a bonding strength between the back plate and the solar cell, and reduce a distance between the back plate and the solar cell and/or a distance between the front plate and the solar cell, thereby improving the stability of the solar cell module.

In another aspect, an embodiment of the present disclosure further provides a manufacturing method of any encapsulant film described above, as shown in FIG. 5, including:
forming a material film by using the encapsulant; and
treating the material film so that the material film is formed into any encapsulant film described above, wherein, the encapsulant film is configured to be used for a solar cell module, and the solar cell module includes a plurality of welding strips, and wherein, the encapsulant film includes: a first region, an orthogonal projection of the first region on a surface where the solar cell module is located overlaps at least partially an orthogonal projection of at least one of the plurality of welding strips, and a film thickness of the first region is different from a film thickness of an other region of the encapsulant film.

For example, the film thickness of the first region is greater than the film thickness of the other region of the encapsulant film.

For the specific features of the encapsulant film, reference may be made to any of the above embodiments, and details will not be described here for brevity.

For example, the treating the material film may include: forming a photoresist material on the material film; exposing the photoresist material by using a mask, a pattern of the mask corresponding to the other region of the encapsulant film; exposing and developing the photoresist material to form a photoresist pattern, a reserved region of the photoresist pattern corresponding to the first region; and etching the material film to remove at least a portion of the material film in the other region.

For example, the forming a material film by using the encapsulant includes: forming a first material film with an encapsulant; and forming an adhesive film spacer on a local region of the first material film to form the material film, wherein, the local region corresponds to the first region. In this way, the encapsulant film of the first region is formed to have two layers, while the encapsulant film of the other region remains as one layer, so that the film thickness of the first region is greater than the film thickness of the other region.

When the encapsulant film includes a mixture of polymer materials, the forming the first material film by using the encapsulant may be: mixing the encapsulant to form the first material film. For the encapsulant, reference may be made to the materials described above in the corresponding embodiments of the encapsulant film, and details will not be described here for brevity. For example, when the encapsulant film includes a mixture of polymer materials, the material film may be made after mixing two or three of ethylene-vinyl acetate copolymer (EVA), polyolefin elastomer (POE) or polyvinyl butyral (PVB). When the encapsulant film includes a three-layer co-extruded material (EPE) of ethylene-vinyl acetate copolymer, polyolefin elastomer and ethylene-vinyl acetate copolymer, three rows of co-extrusion dies may be used to extrude three kinds of materials at different times to form a material film including the EPE co-extruded material.

For example, when the encapsulant film is a three-layer co-extruded material, such as the EPE co-extruded material, the forming a material film by using the encapsulant may include: forming the material film by using a co-extrusion device, which includes: using four rows to six rows of co-extrusion die heads, loading EVA, POE and PVB respectively into a first row to a third row of co-extrusion die heads; and for a fourth row to a sixth row of co-extrusion die heads, only a die head corresponding to the first region may be turned on so that only the encapsulant may be further disposed corresponding to the first region, for example, the fourth row to the sixth row of co-extrusion die heads may be loaded with EVA, POE and PVB respectively, or the fourth row, the fourth row and the fifth row, or the fourth row to the sixth row of co-extrusion die heads may be loaded with any encapsulant; those skilled in the art may choose to use one, two or all of the fourth row to the sixth row of co-extrusion die heads according to a thickness difference between the first region and the other region, and the materials loaded in the fourth row to the sixth row may also be selected as required; upon manufacturing, only the die head corresponding to the first region needs to be opened, which is not limited by the embodiments of the present disclosure.

For example, the forming a material film by using the encapsulant may include: forming the material film using a co-extrusion device, wherein, at least two rows of co-extrusion die heads may be used, of which at least one row of co-extrusion die heads is used to form a first layer of encapsulant, and at least one row of co-extrusion die heads is used to form a second layer of encapsulant. When forming the second layer of encapsulant, only the co-extrusion die heads corresponding to the first region needs to be opened.

For example, a width of the co-extrusion die head may correspond to the welding strip, so that the material extruded therefrom corresponds to the first region corresponding to the welding strip; when each co-extrusion die head is relatively narrow, multiple co-extrusion die heads may correspond to the region corresponding to one welding strip, and those skilled in the art may select as required.

For example, treating the material film so that the material film is formed into any encapsulant film described above, may include: cooling the material film, for example, cooling the material film using a casting roll, shaping after an embossing process, and then trimming, winding, etc.

The material film is cooled immediately after the encapsulant is extruded from the co-extrusion device using the co-extrusion die head. For example, when forming a multi-layer co-extruded material, one layer of material may be extruded first, and then a second layer of material may be extruded on the first layer of material after a predetermined time, and a next layer of material may be extruded after a predetermined time, where the predetermined time should be greater than zero and less than a cooling time of the material, that is, the next layer of material is applied before a lower layer of material is completely cooled and solidified, so that upper and lower layers can be layered and have sufficient bonding strength with each other. Of course, those skilled in the art may also use other methods for this layered co-extruded material, which is not limited by the embodiments of the present disclosure.

In another aspect, an embodiment of the present disclosure further provides a manufacturing method of a solar cell module as described above. The manufacturing method includes: providing the solar cell string; arranging a plurality of welding strips on at least one surface of the solar cell string; arranging an encapsulant film on the plurality of welding strips, wherein, a first region of the encapsulant film is aligned with at least one of the plurality of welding strips; arranging a back plate material on the encapsulant film; laminating with a laminator to form a laminate member, the encapsulant film being formed as an encapsulant layer, wherein, a film thickness of the first region is different from a film thickness of an other region of the encapsulant film.

It should be noted that the encapsulant film here is the encapsulant film described in the above embodiments obtained by using the above manufacturing method. For brevity, what are the same as those in the above embodiments will not be repeated here. For details, reference may be made to the above embodiments.

For example, the manufacturing method may further include: performing trimming inspection; applying the sealing material 6 and the sealant 8; and further setting the frame 9.

For example, laminating with a laminator to form a laminate may include: when a lamination temperature is 145°C., vacuuming the laminator for 8 minutes, where a lamination time is 10 minutes.

For example, laminating with a laminator may also use step-by-step lamination. A pressure of a first lamination may be 0 to 300 mbar, and a pressure of a second lamination may be 300 to 1000 mbar, so that the pressure of each lamination is appropriately reduced through step-by-step lamination, thereby reducing a hidden crack rate of the solar cell module.

For example, providing the solar cell string may include: using a stringer to make a solar cell string with 12 half-cells in each string.

For example, an exemplary manufacturing method may include: manufacturing according to a design, and using a stringer to make a solar cell string with 12 half-cells in each string; laying a front plate material glass and an encapsulant on the front surface; connecting the solar cell string in series or in parallel according to a circuit requirement using a busbar or any other conductor, and disposing a lead wire; laying an encapsulant film on the back surface such that the first region is at least aligned with the welding string of the solar cell string; laying the back plate material, and carrying out inspection and test; entering the laminator for lamination to form a laminate member; and performing trimming inspection, applying a sealing material and a sealant, installing a frame and a junction box and carrying out other subsequent steps to form a solar cell module.

For example, another exemplary manufacturing method may include: forming a solar cell string according to the design; laying a front plate material glass and a front surface encapsulant of EVA/POE/EVA co-extruded material; connecting the solar cell string in series or in parallel according to a circuit requirement using a busbar or any other conductor, and setting a lead wire; laying an encapsulant film on the back surface, such as the encapsulant film formed by EVA/POE/EVA co-extruded material, where the first region of the encapsulant film is at least aligned with the welding strip region in the solar cell string; laying the sealing material around, laying the back plate glass, and carrying out inspection and test; and entering the laminator for lamination to form a laminate member. The lamination process may be: when a lamination temperature is 145°C, performing trimming inspection; installing a desiccant around the laminated module; and applying sealant, and installing a frame and a junction box, etc. to form a solar cell module.

Alternatively, the arranging an encapsulant film on the plurality of welding strips may further include: arranging the first region to be aligned with gaps between the plurality of cells included in the solar cell module. Alternatively, the arranging an encapsulant film on the plurality of welding strips may further include: arranging the first region to be aligned with the peripheral region of the solar cell module. Thus, it provides better protection for solar cell module and stabilizes the performance thereof.

The encapsulant film and manufacturing method thereof, and the solar cell module and manufacturing method thereof provided by the embodiments of the present disclosure have the following beneficial effects:
1. The welding strip corresponds to the first region of the encapsulant film, so that in a case where the amount of encapsulant used is reduced, it can be ensured that after lamination, the packaging adhesive film can wrap the back surface of the welding strip away from the solar cell, the welding strip is fully protected, a distance between the back plate material and the solar cell is reduced, so that the back plate material and the solar cell can be better bonded;
2. The first region where the film thickness of the encapsulant film is relatively thick may also correspond to the gap between the solar cells and/or the periphery of the solar cell module, so that the front plate and the back plate can be better bonded with the solar cells, to improve the stability of the solar cell module;
3. Double-layer sealing is used for the solar cell module, and a desiccant is added between the double-layer sealing, thereby further preventing water vapor from infiltrating from around the module to damage the solar cell module, and improving the stability and performance of the solar cell module.

What are described above is related to the specific embodiments of the disclosure only and not limitative to the scope of the disclosure. The protection scope of the disclosure shall be based on the protection scope of the claims. Any modification and equivalent replacement may be made by those skilled in the art within the protection scope of the claims.

## Claims

1. An encapsulant film (5), configured for manufacturing a solar cell module, wherein the solar cell module comprises a plurality of welding strips (11), and wherein the solar cell module comprises a plurality of solar cells (19), the encapsulant film (5) comprising:
a first region (5a) aligned with at least one of the plurality of welding strips (11), so that during the manufacturing of said solar cell module an orthogonal projection of the first region (5a) on a surface where the solar cell module is located overlaps an orthogonal projection of at least one of the plurality of welding strips (11),
the orthogonal projection of the first region (5a) on the surface where the solar cell module is located overlaps at least partially an orthogonal projection of a gap between the solar cells (19),
and wherein the orthogonal projection of the first region (5a) on the surface where the solar cell module is located overlaps at least partially an orthogonal projection of a peripheral region of the solar cell module,
wherein before manufacturing said solar cell module, a film thickness of the first region (5a) is greater than a film thickness of an other region (5b) of the encapsulant film (5);
wherein a film thickness of the first region (5a) overlapping at least partially an orthogonal projection of a gap between the solar cells (19) and/or a film thickness of the first region (5a) overlapping at least partially an orthogonal projection of a peripheral region of the solar cell module are/is greater than a film thickness of the first region (5a) overlapping at least partially the orthogonal projection of at least one of the plurality of welding strips (11).

2. The encapsulant film (5) according to claim 1, wherein the film thickness of the other region (5b) is zero, and the encapsulant film (5) is in a hollow grid shape.

3. The encapsulant film (5) according to claim 1, wherein an encapsulant film (5) of the first region (5a) comprises two layers of encapsulant, and an encapsulant film (5) of the other region (5b) comprises one layer of encapsulant.

4. The encapsulant film (5) according to claim 1, wherein the encapsulant film (5) comprises an encapsulant, and the encapsulant comprises one or more of ethylene-vinyl acetate copolymer (EVA), polyolefin elastomer (POE) and polyvinyl butyral (PVB).

5. The encapsulant film (5) according to claim 4, wherein the encapsulant comprises a co-extruded material (EPE) of ethylene-vinyl acetate copolymer, polyolefin elastomer and ethylene-vinyl acetate copolymer, wherein the polyolefin elastomer is one or more of copolymers of ethylene and butene, ethylene and pentene, ethylene and hexene, and ethylene and octene.

6. The encapsulant film (5) according to claim 1, wherein the film thickness of the first region (5a) is 0.4 mm to 0.6 mm, and the film thickness of the other region (5b) is 0.1 mm to 0.3 mm.

7. A manufacturing method of a solar cell module, the manufacturing method comprising:
providing the solar cell string (1) comprising a plurality of solar cells (19) connected to each other; arranging a plurality of welding strips (11) on at least one surface of the solar cell string (1);
arranging an encapsulant film (5) according to any of claims 1 to 6 on the plurality of welding strips (11), wherein the first region (5a) of the encapsulant film (5) is aligned with at least one of the plurality of welding strips (11);
arranging a back plate material (7) on the encapsulant film (5); and
laminating with a laminator to form a laminate member, the encapsulant film (5) being formed as an encapsulant layer (51).

8. The manufacturing method of a solar cell module according to claim 7, wherein, the arranging an encapsulant film (5) on the plurality of welding strips (11), further comprises:
arranging the first region (5a) to be aligned with gaps between the plurality of solar cells (19) comprised in the solar cell module; and
arranging the first region (5a) to be aligned with the peripheral region of the solar cell module.

9. A manufacturing method of the encapsulant film (5) according to one of claims 1 to 6, comprising:
forming a material film by using an encapsulant; and
treating the material film so that the material film is formed into the encapsulant film (5) according to one of claims 1 to 6.

10. The manufacturing method according to claim 9, wherein the treating the material film comprises:
forming a photoresist material on the material film;
exposing the photoresist material by using a mask, a pattern of the mask corresponding to the other region (5b) of the encapsulant film (5);
exposing and developing the photoresist material to form a photoresist pattern, a reserved region of the photoresist pattern corresponding to the first region (5a); and
etching the material film to remove at least a portion of the material film in the other region (5b),
the forming a material film by using an encapsulant, comprises:
forming a first material film by using the encapsulant; and
forming an adhesive film spacer on a local region of the first material film to form the material film,
wherein, the local region corresponds to the first region (5a).

## Patentansprüche

1. Verkapselungsfolie (5), die zur Herstellung eines Solarzellenmoduls ausgelegt ist, wobei das Solarzellenmodul mehrere Schweißstreifen (11) umfasst und wobei das Solarzellenmodul mehrere Solarzellen (19) umfasst, wobei die Verkapselungsfolie (5) Folgendes umfasst:
einen ersten Bereich (5a), der mit mindestens einem der mehreren Schweißstreifen (11) ausgerichtet ist, sodass während der Herstellung des Solarzellenmoduls ein orthogonaler Fortsatz des ersten Bereichs (5a) auf einer Oberfläche, wo sich das Solarzellenmodul befindet, einen orthogonalen Fortsatz mindestens eines der mehreren Schweißstreifen (11) überlappt, der orthogonale Fortsatz des ersten Bereichs (5a) auf der Oberfläche, wo sich das Solarzellenmodul befindet, mindestens einen orthogonalen Fortsatz eines Spalts zwischen den Solarzellen (19) überlappt, und wobei der orthogonale Fortsatz des ersten Bereichs (5a) auf der Oberfläche, wo sich das Solarzellenmodul befindet, mindestens teilweise einen orthogonalen Fortsatz eines Umfangsbereichs des Solarzellenmoduls überlappt,
wobei vor Herstellung des Solarzellenmoduls eine Foliendicke des ersten Bereichs (5a) größer als eine Foliendicke eines anderen Bereichs (5b) der Verkapselungsfolie (5) ist;
wobei eine Foliendicke des ersten Bereichs (5a), der mindestens teilweise einen orthogonalen Fortsatz eines Spalts zwischen den Solarzellen (19) überlappt, und/oder eine Foliendicke des ersten Bereichs (5a), der mindestens teilweise einen orthogonalen Fortsatz eines Umfangsbereichs des Solarzellenmoduls überlappt, größer als eine Foliendicke des ersten Bereichs (5a) ist/sind, der mindestens teilweise den orthogonalen Fortsatz mindestens eines der mehreren Schweißstreifen (11) überlappt.

2. Verkapselungsfolie (5) nach Anspruch 1, wobei die Foliendicke des anderen Bereichs (5b) null beträgt und die Verkapselungsfolie (5) eine Hohlgitterform ist.

3. Verkapselungsfolie (5) nach Anspruch 1, wobei eine Verkapselungsfolie (5) des ersten Bereichs (5a) zwei Verkapselungsschichten umfasst und eine Verkapselungsfolie (5) des anderen Bereichs (5b) eine Verkapselungsschicht umfasst.

4. Verkapselungsfolie (5) nach Anspruch 1, wobei die Verkapselungsfolie (5) ein Verkapselungsmaterial umfasst und das Verkapselungsmaterial eines oder mehrere von Ethylen-Vinylacetat-Copolymer (EVA), Polyolefin-Elastomer (POE) und Polyvinylbutyral (PVB) umfasst.

5. Verkapselungsfolie (5) nach Anspruch 4, wobei das Verkapselungsmaterial ein co-extrudiertes Material (EPE) von Ethylen-Vinylacetat-Copolymer, Polyolefin-Elastomer und Ethylen-Vinylacetat-Copolymer umfasst, wobei das Polyolefin-Elastomer eines oder mehrere von Copolymeren von Ethylen und Buten, Ethylen und Penten, Ethylen und Hexen und Ethylen und Octen ist.

6. Verkapselungsfolie (5) nach Anspruch 1, wobei die Foliendicke des ersten Bereichs (5a) 0,4 mm bis 0,6 mm beträgt und die Foliendicke des anderen Bereichs (5b) 0,1 mm bis 0,3 mm beträgt.

7. Herstellungsverfahren für ein Solarzellenmodul, wobei das Herstellungsverfahren Folgendes umfasst:
Bereitstellen des Solarzellenstrangs (1), der mehrere Solarzellen (19) umfasst, die miteinander verbunden sind;
Anordnen mehrerer Schweißstreifen (11) auf mindestens einer Oberfläche des Solarzellenstrangs (1);
Anordnen einer Verkapselungsfolie (5) nach einem der Ansprüche 1 bis 6 auf den mehreren Schweißstreifen (11), wobei der erste Bereich (5a) der Verkapselungsfolie (5) mit mindestens einem der mehreren Schweißstreifen (11) ausgerichtet ist;
Anordnen eines Rückwandmaterials (7) auf der Verkapselungsfolie (5); und
Laminieren mit einem Laminator, um ein Laminatelement zu bilden, wobei die Verkapselungsfolie (5) als eine Verkapselungsschicht (51) gebildet wird.

8. Herstellungsverfahren für ein Solarzellenmodul nach Anspruch 7, wobei das Anordnen einer Verkapselungsfolie (5) auf den mehreren Schweißstreifen (11) weiter Folgendes umfasst:
Anordnen des ersten Bereichs (5a) in Ausrichtung mit Spalten zwischen den mehreren Solarzellen (19), die in dem Solarzellenmodul umfasst sind; und
Anordnen des ersten Bereichs (5a) in Ausrichtung mit dem Umfangsbereich des Solarzellenmoduls.

9. Herstellungsverfahren der Verkapselungsfolie (5) nach einem der Ansprüche 1 bis 6, das Folgendes umfasst:
Bilden einer Materialfolie unter Verwendung eines Verkapselungsmaterials; und
Behandeln der Materialfolie, sodass die Materialfolie zu der Verkapselungsfolie (5) nach einem der Ansprüche 1 bis 6 gebildet wird.

10. Herstellungsverfahren nach Anspruch 9, wobei das Behandeln der Materialfolie Folgendes umfasst:
Bilden eines Fotolackmaterials auf der Materialfolie;
Belichten des Fotolackmaterials unter Verwendung einer Maske, wobei eine Struktur der Maske dem anderen Bereich (5b) der Verkapselungsfolie (5) entspricht;
Belichten und Entwickeln des Fotolackmaterials, um eine Fotolackstruktur zu bilden, wobei ein reservierter Bereich der Fotolackstruktur dem ersten Bereich (5a) entspricht; und
Ätzen der Materialfolie, um mindestens einen Abschnitt der Materialfolie in dem anderen Bereich (5b) zu entfernen,
das Bilden einer Materialfolie unter Verwendung eines Verkapselungsmaterials Folgendes umfasst:
Bilden einer ersten Materialfolie unter Verwendung des Verkapselungsmaterials; und
Bilden eines Haftfolienabstandhalters auf einem lokalen Bereich der ersten Materialfolie, um die Materialfolie zu bilden,
wobei der lokale Bereich dem ersten Bereich (5a) entspricht.

## Revendications

1. Film d'encapsulation (5), configuré pour fabriquer un module de cellules solaires, dans lequel le module de cellules solaires comprend une pluralité de bandes de soudure (11), et dans lequel le module de cellules solaires comprend une pluralité de cellules solaires (19), le film d'encapsulation (5) comprenant :
une première région (5a) alignée sur au moins l'une de la pluralité de bandes de soudure (11) de sorte que, pendant la fabrication dudit module de cellules solaires, une projection orthogonale de la première région (5a) sur une surface où se trouve le module de cellules solaires chevauche une projection orthogonale d'au moins l'une de la pluralité de bandes de soudure (11),
la projection orthogonale de la première région (5a) sur la surface où se trouve le module de cellules solaires chevauche au moins partiellement une projection orthogonale d'un espace entre les cellules solaires (19),
et dans lequel la projection orthogonale de la première région (5a) sur la surface où se trouve le module de cellules solaires chevauche au moins partiellement une projection orthogonale d'une région périphérique du module de cellules solaires,
dans lequel, avant la fabrication dudit module de cellules solaires, une épaisseur de film de la première région (5a) est plus grande qu'une épaisseur de film d'une autre région (5b) du film d'encapsulation (5) ;
dans lequel une épaisseur de film de la première région (5a) chevauchant au moins partiellement une projection orthogonale d'un espace entre les cellules solaires (19) et/ou une épaisseur de film de la première région (5a) chevauchant au moins partiellement une projection orthogonale d'une région périphérique du module de cellules solaires sont plus grandes qu'une épaisseur de film de la première région (5a) chevauchant au moins partiellement la projection orthogonale d'au moins l'une de la pluralité de bandes de soudure (11).

2. Film d'encapsulation (5) selon la revendication 1, dans lequel l'épaisseur de film de l'autre région (5b) est zéro, et le film d'encapsulation (5) présente une forme de grille creuse.

3. Film d'encapsulation (5) selon la revendication 1, dans lequel un film d'encapsulation (5) de la première région (5a) comprend deux couches d'agent d'encapsulation, et un film d'encapsulation (5) de l'autre région (5b) comprend une couche d'agent d'encapsulation.

4. Film d'encapsulation (5) selon la revendication 1, dans lequel le film d'encapsulation (5) comprend un agent d'encapsulation, et l'agent d'encapsulation comprend un ou plusieurs parmi un copolymère éthylène-acétate de vinyle (EVA), un élastomère de polyoléfine (POE) et du polybutyral de vinyle (PVB).

5. Film d'encapsulation (5) selon la revendication 4, dans lequel l'agent d'encapsulation comprend un matériau coextrudé (EPE) de copolymère éthylène-acétate de vinyle, élastomère de polyoléfine et copolymère éthylène-acétate de vinyle, dans lequel l'élastomère de polyoléfine est un ou plusieurs parmi des copolymères d'éthylène et de butène, d'éthylène et de pentène, d'éthylène et d'hexène, et d'éthylène et d'octène.

6. Film d'encapsulation (5) selon la revendication 1, dans lequel l'épaisseur de film de la première région (5a) est de 0,4 mm à 0,6 mm, et l'épaisseur de film de l'autre région (5b) est de 0,1 mm à 0,3 mm.

7. Procédé de fabrication d'un module de cellules solaires, le procédé de fabrication comprenant :
la fourniture de la chaîne de cellules solaires (1) comprenant une pluralité de cellules solaires (19) reliées les unes aux autres ;
l'agencement d'une pluralité de bandes de soudure (11) sur au moins une surface de la chaîne de cellules solaires (1) ;
l'agencement d'un film d'encapsulation (5) selon l'une quelconque des revendications 1 à 6 sur la pluralité de bandes de soudure (11), dans lequel la première région (5a) du film d'encapsulation (5) est alignée sur au moins l'une de la pluralité de bandes de soudure (11) ;
l'agencement d'un matériau de plaque arrière (7) sur le film d'encapsulation (5) ; et
la lamination avec un lamineur pour former un élément laminé, le film d'encapsulation (5) étant formé comme une couche d'encapsulation (51).

8. Procédé de fabrication d'un module de cellules solaires selon la revendication 7, dans lequel l'agencement d'un film d'encapsulation (5) sur la pluralité de bandes de soudure (11) comprend en outre :
l'agencement de la première région (5a) à aligner sur des espacements entre la pluralité de cellules solaires (19) comprises dans le module de cellules solaires ; et
l'agencement de la première région (5a) à aligner sur la région périphérique du module de cellules solaires.

9. Procédé de fabrication du film d'encapsulation (5) selon l'une des revendications 1 à 6, comprenant :
la formation d'un film de matériau à l'aide d'un agent d'encapsulation ; et
le traitement du film de matériau de sorte que le film de matériau soit formé dans le film d'encapsulation (5) selon l'une des revendications 1 à 6.

10. Procédé de fabrication selon la revendication 9, dans lequel le traitement du film de matériau comprend :
la formation d'un matériau de photorésine sur le film de matériau ;
l'exposition du matériau de photorésine à l'aide d'un masque, un motif du masque correspondant à l'autre région (5b) du film d'encapsulation (5) ;
l'exposition et le développement du matériau de photorésine pour former un motif de photorésine, une région réservée du motif de photorésine correspondant à la première région (5a) ; et
la gravure du film de matériau pour enlever au moins une partie du film de matériau dans l'autre région (5b),
la formation d'un film de matériau à l'aide d'un agent d'encapsulation comprend :
la formation d'un premier film de matériau à l'aide de l'agent d'encapsulation ; et
la formation d'un espaceur à film adhésif sur une région locale du premier film de matériau pour former le film de matériau,
dans lequel la région locale correspond à la première région (5a).
